# EUROPEAN PATENT SPECIFICATION

(11) **EP 0 567 063 B1**
(45) Date of publication and mention of the grant of the patent: **04.03.1998**
(21) Application number: 93106374.7
(22) Date of filing: 20.04.1993
(51) Int. Cl.: H01L 21/311, H01L 41/24, H01L 39/24, C04B 41/53

(54) **Anisotropic metal oxide etch**
Anisotropische Ätzung von Metalloxid
Gravure anisotrope d'oxydes métalliques

(30) Priority: 20.04.1992 US 870988; 20.04.1992 US 871862; 20.04.1992 US 871863; 20.04.1992 US 872701; 20.04.1992 US 872702
(43) Date of publication of application: 27.10.1993
(73) Proprietor: TEXAS INSTRUMENTS INCORPORATED, Dallas Texas 75265 (US)
(72) Inventor: Douglas, Monte A., Coppell, TX 75019 (US); Summerfelt, Scott R., Dallas, TX 75243 (US); Beratan, Howard R., Richardson, TX 75081 (US)
(74) Representative: Schwepfinger, Karl-Heinz, Dipl.-Ing.

(56) References cited:
- US-A- 4 661 201
- US-A- 4 978 418
- APPLIED PHYSICS LETTERS. vol. 54, no. 13 , 27 March 1989 , NEW YORK US pages 1272 - 1274 HUSSEY ET AL 'Laser-assisted etching of YBa2Cu3O7-delta'
- JAPANESE JOURNAL OF APPLIED PHYSICS, SUPPLEMENT 26-2. vol. 26 , 1987 , TOKYO JA pages 159 - 161 SHIOSAKI ET AL 'Machining of PZT, PT and (Mn, Zn)Fe2O4 ceramics by laser-induced chemical etching'
- APPLIED PHYSICS LETTERS. vol. 52, no. 18 , 2 May 1988 , NEW YORK US pages 1523 - 1524 SHIH ET AL 'Chemical etching of Y-Cu-Ba-O thin films'
- JAPANESE JOURNAL OF APPLIED PHYSICS. vol. 29, no. 10 , October 1990 , TOKYO JP pages 2307 - 2311 FUJIWARA ET AL 'Ion bombardment enhanced etching for Bi-Ca-Sr-Cu-O high-Tc superconducting thin films'
- PATENT ABSTRACTS OF JAPAN vol. 16, no. 383 (C-0974)17 August 1992 & JP-A-04 124 078 (CANON) 24 April 1992
- IBM TECHNICAL DISCLOSURE BULLETIN. vol. 27, no. 12 , May 1985 , NEW YORK US page 7238 ANONYMOUS 'Process for selective etching of tantalum oxide'

## Description

### Field of the Invention

This invention generally relates to methods of anisotropically etching metal oxide materials.

### Background of the Invention

Without limiting the scope of the invention, its background is described in connection with current methods of etching metal oxides, as an example.

Metal oxide materials, because of their electrical and mechanical properties, have found many uses in the field of electronics. Examples of these useful metal oxide materials are barium strontium titanate (BaSrTiO₃, hereafter referred to as BST), lead zirconate titanate (PbTiZrO₃, hereafter referred to as PZT), niobium pentoxide (Nb₂O₅) and tantalum pentoxide (Ta₂O₅). The very high dielectric constants exhibited by many metal oxide compounds make them useful as the dielectric material in capacitors, especially in the miniature capacitors which are built into many integrated circuits (e.g dynamic RAMs). Many metal oxide materials also have a positive temperature coefficient of electrical resistance, which allows devices to be made which protect electrical motors from damage due to over-current conditions. The piezoelectrical properties of these materials are widely used, as in the precise control of the length of laser cavities, for example. Microminiature structures which incorporate metal oxide materials are being used to sense infrared radiation, obviating the need for bandgap detector materials which require cryogenic cooling to sense the infrared.

Metal oxide materials are often etched during the fabrication of the electrical devices which exploit their beneficial properties. A method used to etch metal oxides should generally do so without introducing damage which would unacceptably change the properties of the material on which the function of the eventual devices depends. In addition, an anisotropic etch method is usually desired so that detail in the etch mask pattern is preserved. Contamination of the metal oxide material (and/or nearby materials) by the etch method usually cannot be tolerated.

Heretofore, in this field, metal oxides have been etched by isotropic wet etching, ion-milling, plasma etching or laser scribing. Laser scribing is a method wherein selected portions of the material are damaged and weakened by exposure to intense laser radiation and then removed.

In "Applied Physics Letters, Vol. 54, No. 13, 27-03-1989, pages 1272 to 1274" a method of thermally activated laser etching is described which is suitable for anisotropically etching a surface of a metal oxide material, the surface being submersed in a liquid etchant when said etching step is carried out.

In Japanese Journal of Applied Physics, Vol. 26, (1987) Supplement 26-2, pages 159-161, a method for localized etching of semiconductors and ceramics is described, which uses thermal or optical excitation of the etchant and/or workpiece.

### Summary of the Invention

It has been discovered that current methods of etching metal oxide materials can produce unacceptable results. Isotropic wet etching can undercut the etch mask (generally by the same distance as the etch depth), leading to features in the underlying metal oxide material which are not true to the etch mask pattern. Ion-milling can generate unacceptable defects in the metal oxide material, including changes in its electrical, chemical, mechanical, optical, and/or magnetic properties. Plasma etching can cause damage similar to that caused by ion-milling, and in addition the plasma constituent elements can contaminate substrate materials and are often difficult to remove. Etching by laser scribing can result in no undercut of the material, but the laser radiation can cause damage to the metal oxide material which must be repaired by a high-temperature (approximately 1400 °C) anneal. This anneal may produce undesirable oxidation states in the metal oxide material, reducing its beneficial properties. High temperature anneals, in addition, can cause changes and damage to other materials and structures present in the substrate.

The present invention discloses a method for anisotropically etching as out lined in the claims.

An advantage of the invention is that it anisotropic (i.e does not cause substantial undercut). Those regions under the mask remain in shadow and are not appreciably etched. In addition, it has been found that this method does not cause unacceptable defects in the metal oxide material. Contamination from plasma species is prevented. Generally, no high temperature anneal is required.

### Brief Description of the Drawing

The novel features believed characteristic of the invention are set forth in the appended claims. The invention itself, however, as well as other features and advantages thereof, will be best understood by reference to the detailed description which follows, read in conjunction with the accompanying drawing.

In the drawing:

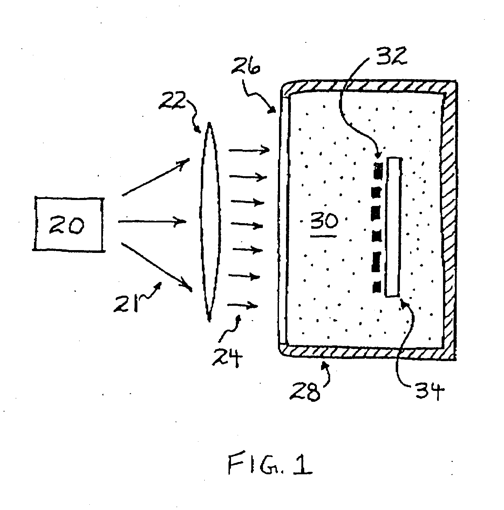

FIG. 1 is a representation of the apparatus and materials used to anisotropically etch metal oxide materials.

### Detailed Description of the Preferred Embodiments

With reference to Fig. 1, a pattern is etched into a substrate **34** off barium strontium titanate (BaSrTiO₃) which is immersed in 12 molar concentration hydrochloric acid (HCl) **30** and illuminated with substantially collimated visible/ultraviolet radiation **24** propagating substantially orthogonal to the substrate surface **34** produced by a 200 Watt mercury xenon arc lamp **20.** Radiation **21** from the radiation source **20** is collimated by collimating optics **22** and the resulting collimated radiation **24** is directed at the substrate **34**. A window **26** which is a portion of the reaction vessel **28** and which is substantially transparent to the collimated radiation allows the radiated energy to reach the BST substrate **34.** An etch mask **32** defines the etched pattern by blocking the radiation at portions of the substrate. The BST substrate **34** and acid solution **30** are nominally at a temperature of 25 °C. At such a temperature and acid concentration and without illumination, BST is not appreciably etched by HCl. Upon illumination by visible/ultraviolet radiation produced by the lamp, however, the etch rate becomes approximately one micron per hour.

The etch mask **32** between the radiation source **20** and the BST substrate **34** is preferably located close to or in contact with the surface to be etched. Such an etch mask **32** may be deposited onto the substrate substrate surface. The etch mask **32** is preferably made of silicon oxide. In general, any substance which is sufficiently opaque to visible and ultra violet light such as that produced by the mercury xenon lamp and which is not substantially penetrated of etched by the liquid ambient may be used, such as silicon oxide or silicon nitride. Noble metals such as platinum may be used. Those areas of the substrate not covered by the mask material will be subject to etching by the acid solution.

Sidewall profile control is enhanced by introducing a passivating agent into the liquid ambient **30** that does not react with the BST to form a soluble product or only slightly soluble product. The passivating agent "poisons" the sidewalls with respect to attack by other etch reagents on the sidewall, but does not stop etching normal to the substrate because the irradiation detaches the passivating agent from the surface. An example of a passivating agent in an etch of BST is phosphoric acid.

Again with reference to Fig.1, a pattern is etched into a substrate **34** of niobium pentoxide (Nb₂O₅) which is immersed in 10% hydrofluoric acid acid (HF) **30** and illuminated with substantially collimated visible/ultraviolet radiation **24** propagating substantially orthogonal to the substrate surface **34** produced by a 200 Watt mercury xenon arc lamp **20**. Radiation **21** from the radiation source **20** is collimated by collimating optics **22** and the resulting collimated radiation **24** is directed at the substrate **34.** A window **26** which is a portion of the reaction vessel **28** and which is substantially transparent to the collimated radiation allows the radiated energy to reach the Nb₂O₅ substrate **34.** An etch mask **32** defines the etched pattern by blocking the radiation at portions of the substrate. The Nb₂O₅ substrate **34** and acid solution **30** are nominally at a temperature of 25 °C. At such a temperature and acid concentration and without illumination, Nb₂O₅ is not appreciably etched. Upon illumination by vsible/ultraviolet radiation produced by the lamp, however, the etch rate is increased. Etch rate ratios as high as 9:1 (illuminated:unilluminated) have been observed.

The etch mask **32** between the radiation source **20** and the Nb₂O₅ substrate **34** is preferably located close to or in contact with the surface to be etched. Such an etch mask **32** may be deposited onto the substrate surface. The etch mask **32** is preferably an organic photoresist. In general, any substance which is sufficiently opaque to visible and ultraviolet light such as that produced by the mercury xenon lamp and which is not substantially penetrated or etched by the liquid ambient may be used. Noble metals such as platinum may be used. Those areas of the substrate not covered by the mask material will be subject to etching.

Sidewall profile control is enhanced by introducing a passivating agent into the liquid ambient **30** that does not react with the Nb₂O₅ to form a soluble product or only slightly soluble product. The passivating agent "poisons" the sidewalls with respect to attack by other etch reagents on the sidewall, but does not stop etching normal to the substrate because the irradiation detaches the passivating agent from the surface. An example of a passivating agent in an etch of Nb₂O₅ is hydrochloric acid.

Again with reference to Fig. 1, a pattern is etched into a substrate **34** of tantalum pentoxide (Ta₂O₅) which is immersed in 10% hydrofluoric acid (HF) **30** and illuminated with substantially collimated visible/ultraviolet radiation **24** propagating substantially orthogonal to the substrate surface **34** produced by a 200 Watt mercury xenon arc lamp **20**. Radiation **21** from the radiation source **20** is collimated by collimating optics **22** and the resulting collimated radiation **24** is directed at the substrate **34**. A window **26** which is a portion of the reaction vessel **28** and which is substantially transparent to the collimated radiation allows the radiated energy to reach the Ta₂O₅ substrate **34**. An etch mask **32** defines the etched pattern by blocking the radiation at portions of the substrate. The Ta₂O₅ substrate **34** and acid solution **30** are nominally at a temperature of 25 °C. At such a temperature and acid concentration and without illumination, Ta₂O₅ is not appreciably etched. Upon illumination by visible/ultraviolet radiation produced by the lamp, however, the etch rate is increased. Etch rate ratios as high as 50:1 (illuminated:unilluminated) have been observed.

The etch mask **32** between the radiation source **20** and the Ta₂O₅ substrate **34** is preferably located close to or in contact with the surface to be etched. Such an etch mask **32** may be deposited onto the substrate surface. The etch mask **32** is preferably an organic photoresist. In general, any substance which is sufficiently opaque to visible and ultraviolet light such as that produced by the mercury xenon lamp and which is not substantially penetrated or etched by the liquid ambient may be used. Noble metals such as platinum may be used. Those areas of the substrate not covered by the mask material will be subject to etching.

Sidewall profile control is enhanced by introducing a passivating agent into the liquid ambient **30** that does not react with the Ta₂O₅ to form a soluble product or only slightly soluble product. The passivating agent "poisons" the sidewalls with respect to attack by other etch reagents on the sidewall, but does not stop etching normal to the substrate because the irradiation detaches the passivating agent from the surface. An example of a passivating agent in an etch of Ta₂O₅ is hydrochloric acid.

With reference to Fig. 1, a pattern is etched into a substrate **34** of lead zirconate titanate (PbTiZrO₃ or PZT) which is immersed in 12 molar concentration hydrochloric acid HCl) **30** and illuminated with substantially collimated visible/ultraviolet radiation **24** propagating substantially orthogonal to the substrate surface **34** produced by a 200 Watt mercury xenon arc lamp **20.** Radiation **21** from the radiation source **20** is collimated by collimating optics **22** and the resulting collimated radiation **24** is directed at the substrate **34**. A window **26** which is a portion of the reaction vessel **28** and which is substantially transparent to the collimated radiation allows the radiated energy to reach the PZT substrate **34**. An etch mask **32** defines the etched pattern by blocking the radiation at portions of the substrate. The PZT substrate **34** and acid solution **30** are nominally at a temperature of 25 °C. At such a temperature and acid concentration and without illumination, PZT is not appreciably etched by HCl. Upon illumination by visible/ultraviolet radiation produced by the lamp, however, the etch rate is increased. It is believed, in part because of the relatively low power of the light source, that the etching reaction is accelerated in the illuminated areas because of electronic excitation due to photo-irradiation rather than from thermal effects. As used herein, the term "radiation" means radiation at levels above background and this means, for example, illumination at levels substantially greater than room lighting.

The etch mask **32** between the radiation source **20** and the PZT substrate **34** is preferably located close to or in contact with the surface to be etched. Such an etch mask **32** may be deposited onto the substrate surface. The etch mask **32** is preferably made of silicon oxide. In general, any substance which is sufficiently opaque to visible and ultraviolet light such as that produced by the mercury xenon lamp and which is not substantially penetrated of etched by the liquid ambient may be used, such as silicon oxide or silicon nitride. A noble metal such as platinum may be used. Those areas of the substrate not covered by the mask material will be subject to etching by the acid solution.

Sidewall profile control is enhanced by introducing a passivating agent into the liquid ambient **30** that does not react with the material being etched to form a soluble product or only slightly soluble product. The passivating agent "poisons" the sidewalls with respect to attack by other etch reagents on the sidewall, but does not stop etching normal to the substrate because the irradiation detaches the passivating agent from the surface. An example of a passivating agent in an etch of PZT is phosphoric acid.

For all of the above examples, it is believed, in part because of the relatively low power of the light source, that the etching reaction is accelerated in the illuminated areas because of electronic excitation due to photo-irradiation rather than from thermal effects. As used herein, the term "radiation" means radiation at levels above background and this means, for example, illumination at levels substantially greater than room lighting.

For all of the above examples, the liquid ambient may be form the class of solutions that etch the substrate material without light irradiation. In tins case, the radiation accelerates the etch rate on illuminated portions of the substrate, resulting in a less isotropic etch. Still other alternate embodiments include liquid ambients containing salts and liquid ambients with pH values less than or equal to seven (i.e. acids and neutral solutions). Still other alternate embodiments include liquid ambients with pH values in the alkaline range (i.e. greater than seven), although neutral and acidic solutions are greatly preferred and have given excellent results as described in the preferred embodiments of this invention.

For all of the above examples, a pattern is etched into the surface of the metal oxide material by projecting a patterned light onto the substrate (e.g. by conventional photo-lithographic techniques. Additionally, the liquid ambient may be made to flow with respect to the substrate. The flow rate of the liquid ambient may be varied. The solution temperature can be varied to achieve different etch rates and etch anisotropy. The photon flux may be varied to impact etch directionality and etch rates. The radiation wavelength can be adjusted to achieve different etch directionality and etch rates. The direction of propagation of the radiation need not be normal to the surface The etch solution may be a mixture of species (e.g. one or more passivating agents to enhance anisotropy and one or more reagents to photochemically etch the material).

The sole Table, below, provides an overview of some embodiments and the drawing.

**TABLE**

| **Drawing Element** | **Generic Term** | **Preferred or Specific Terms** | **Alternate Terms** |
|---|---|---|---|
| 20 | Radiation Source | 200 Watt mercury/xenon arc lamp | |
| 21 | Radiation | Visible/UV light | Radiation which will penetrate the liquid ambient |
| 22 | Collimating Optics | | |
| 24 | Collimated Radiation | Visible/UV light propagating normal to substrate surface | |
| 26 | Transparent Window | | |
| 28 | Reaction Vessel | | |
| 30 | Liquid Ambient | 12 Molar Hydrochloric acid | Other etch constituents such as Hydrofluoric acid (HF); |
| | | | Passivating agents: phosphoric acid; HCl |
| | | | Mixtures of both. |
| 32 | Etch Mask | Silicon oxide | Silicon nitride |
| | | | Noble metals such as platinum |
| 34 | Metal oxide Substrate | BaSrTiO₃ Nb₂O₅ Ta₂O₅ PbTiZrO₃ | Titanate Compounds such as lanthanum doped lead zirconium titanate. |
| | | | Transition metal oxides such as LiNbO₃ |

## Claims

1. A method for anisotropically etching a surface of titanate compounds such as barium strontium titanante BaSrTiO₃ or lead zirconate titanate PbTiZrO₃ submerged in hydrochloric acid HCI as liquid etchant, wherein portions of said surface are illuminated with substantially collimated radiation propagating substantially orthogonally to said surface and comprising visible or ultraviolet light or both, the temperature of said illuminated portions of said surface being maintained at substantially the same temperature as the temperature of the unilluminated portions of said surface, said liquid etchant further containing phosphoric acid as a passivating agent to form a substantially insoluble product decreasing the etch rate of said unilluminated portions of said surface, said irradiation detaching the passivating agent from said surface.

2. A method for anisotropically etching a surface of niobium pentoxide Nb₂O₅ or tantalum pentoxide Ta₂O₅ submerged in hydrofluoric acid HF as liquid etchant, wherein portions of said surface are illuminated with substantially collimated radiation propagating substantially orthogonally to said surface and comprising visible or ultraviolet light or both, the temperature of said illuminated portions of said surface being maintained at substantially the same temperature as the temperature of the unilluminated portions of said surface, said liquid etchant further containing hydrochloric acid as a passivating agent to form a substantially insoluble product decreasing the etch rate of said unilluminated portions of said surface, said irradiation detaching the passivating agent from said surface.

3. The method according to claim 1, further comprising providing said HCI as 12 molar HCI.

4. The method according to claim 2, further comprising providing said hydrofluoric acid as 10% hydrofluoric acid.

5. The method according to any preceding claim, further comprising forming said illuminated portions and said unilluminated portions of said surface by a photolithographic technique.

6. The method according to any preceding claim, further comprising moving said liquid etchant with respect to said surface.

## Patentansprüche

1. Verfahren zum aniostropen Ätzen einer Oberfläche von in Salzsäure (HCl) als flüssiges Ätzmittel eingetauchten Titanatverbindungen, wie Bariumstrontiumtitanat (BaSrTiO3) oder Bleizirconattitanat (PbTiZrO3), bei welchem Teile der Oberfläche mit im wesentlichen kollimierter Strahlung beleuchtet werden, die sich im wesentlichen orthogonal zu der Oberfläche ausbreitet und sichtbares oder ultraviolettes Licht oder beides enthält, wobei die beleuchteten Teile der Oberfläche im wesentlichen auf der gleichen Temperatur gehalten werden wie die nicht beleuchteten Teile der Oberfläche, wobei das flüssige Ätzmittel weiter Phosphorsäure als Passivierungsmittel enthält, um ein im wesentlichen unlösliches Produkt zu bilden, durch das die Ätzrate der nicht beleuchteten Teile der Oberfläche verringert wird, wobei die Bestrahlung das Passivierungsmittel von der Oberfläche ablöst.

2. Verfahren zum anisotropen Ätzen einer Oberfläche von in Fluorwasserstoffsäure (HF) als flüssiges Ätzmittel eingetauchtem Niobpentoxid (Nb2O5) oder Tantalpentoxid (Ta2O5), bei welchem Teile der Oberfläche mit im wesentlichen kollimierter Strahlung beleuchtet werden, die sich im wesentlichen orthogonal zu der Oberfläche ausbreitet und sichtbares oder ultraviolettes Licht oder beides enthält, wobei die beleuchteten Teile der Oberfläche im wesentlichen auf der gleichen Temperatur gehalten werden wie die nicht beleuchteten Teile der Oberfläche, wobei das flüssige Ätzmittel weiter Fluorwasserstoffsäure als Passivierungsmittel enthält, um ein im wesentlichen unlösliches Produkt zu bilden, durch das die Ätzrate der nicht beleuchteten Teile der Oberfläche verringert wird, wobei die Bestrahlung das Passivierungsmittel von der Oberfläche ablöst.

3. Verfahren nach Anspruch 1, bei welchem das HCl weiter als 12molares HCl bereitgestellt wird.

4. Verfahren nach Anspruch 2, bei welchem die Fluorwasserstoffsäure weiter als 10%ige Fluorwasserstoffsäure bereitgestellt wird.

5. Verfahren nach einem der vorhergehenden Ansprüche, bei welchem die beleuchteten Teile und die nicht beleuchteten Teile der Oberfläche weiter durch eine photolithographische Technik gebildet werden.

6. Verfahren nach einem der vorhergehenden Ansprüche, bei welchem das flüssige Ätzmittel weiter bezüglich der Oberfläche bewegt wird.

## Revendications

1. Procédé pour gravure anisotrope d'une surface de composés de titanate tels que du titanate de strontium et de barium BaSrTiO₃ ou du titanate de zirconate et de plomb PbTiZrO₃ immergée dans de l'acide chlorhydrique HCI comme agent de gravure liquide, dans lequel des portions de ladite surface sont illuminées avec un rayonnement sensiblement collimaté et se propageant sensiblement orthogonalement à ladite surface et comprenant de la lumière ultraviolette ou visible ou les deux, la température desdites portions illuminées de ladite surface étant maintenues sensiblement à la même température que la température des portions non illuminées de ladite surface, ledit agent de gravure liquide contenant en outre de l'acide phosphorique comme agent de passivation pour former un produit sensiblement insoluble diminuant le taux de gravure desdites portions non illuminées de ladite surface, ladite irradiation détachant l'agent de passivation de ladite surface.

2. Procédé pour gravure anisotrope d'une surface de pentoxyde de niobium Nb₂O₅ ou de pentoxyde de tantale Ta₂O₅ immergée dans de l'acide fluorhydrique HF comme agent de gravure liquide, dans lequel des portions de ladite surface sont illuminées avec un rayonnement sensiblement collimaté se propageant sensiblement orthogonalement à ladite surface et comprenant de la lumière ultraviolette ou visible ou les deux, la température desdites portions illuminées de ladite surface étant maintenue sensiblement à la même température que la température des portions non illuminées de ladite surface, ledit agent de gravure liquide comprenant en outre de l'acide chlorhydrique comme agent de passivation pour former un produit sensiblement insoluble diminuant le taux de gravure desdites portions non illuminées de ladite surface, ladite irradiation détachant l'agent de passivation de ladite surface.

3. Procédé selon la revendication 1, comprenant en outre la fourniture d'HCl comme de l'HCl, 12M.

4. Procédé selon la revendication 2, comprenant en outre la fourniture d'acide fluorhydrique comme de l'acide fluorhydrique à 10%.

5. Procédé selon l'une quelconque des revendications précédentes, comprenant en outre la formation desdites portions illuminées et desdites portions non illuminées de ladite surface par une technique photolithographique.

6. Procédé selon l'une quelconque des revendications précédentes, comprenant en outre le déplacement dudit agent de gravure liquide par rapport à ladite surface.
